# EUROPEAN PATENT SPECIFICATION

(11) **EP 3 886 548 B1**
(45) Date of publication and mention of the grant of the patent: **07.06.2023**
(21) Application number: 20166400.0
(22) Date of filing: 27.03.2020
(51) Int. Cl.: H05K 7/20

(54) **CABINET FOR ELECTRONIC EQUIPMENT AND A COOLING METHOD OF ELECTRONIC EQUIPMENT**
SCHALTSCHRANK FÜR ELEKTRONISCHE GERÄTE UND EIN KÜHLVERFAHREN FÜR ELEKTRONISCHE GERÄTE
ARMOIRE POUR ÉQUIPEMENTS ÉLECTRONIQUES ET MÉTHODE DE REFROIDISSEMENT DES ÉQUIPEMENTS ÉLECTRONIQUES

(43) Date of publication of application: 29.09.2021
(73) Proprietor: CB Borey LLC, Moscow 108811 (RU)
(72) Inventor: FERENTSEV, Anatoliy Aleksandrovich, 630090 Novosibirsk (RU); SHALIMOV, Maksim Yurevich, 630060 Novosibirsk (RU)
(74) Representative: Vitina, Maruta

(56) References cited:
- US-A1- 2014 124 168
- US-A1- 2015 003 009

## Description

### Field of application

The invention's field of application is radio electronics, specifically, cabinets for electronic equipment. The purpose of the invention is the deployment of electronic equipment inside it.

### Background to the invention

A prior design of an electronic equipment cabinet is known (RU 2211551); it comprises a chassis and plates located one above another and thus forming horizontal sections; in the sections are located detachable blocks of radio-electronic equipment and a heat sink system that consists of plates connected to the rear wall of the cabinet; these plates and the rear wall of the cabinet are made of a heat-conducting material; on the external side of the rear wall of the cabinet, fastening means for the heat sink plate with additional cooling means are mounted on the external surface of the cooling system version which is designed for outdoor operation.

A drawback of this cabinet is that under more severe thermal conditions, a plate with additional cooling means has to be installed, which complicates the design of the cabinet and makes it more bulky.

A prior design of an electronic components cabinet is known (RU 168956); it comprises a set of vertical and horizontal racks forming the cabinet frame and at least two vertical panels made of vertical and horizontal racks and fastened in the cabinet frame; here the vertical panels of the frame have a set of fasteners for accommodating the electronic components to be cooled between them; the vertical panels have at least one vertical duct for supplying the cooled down coolant and another vertical duct for returning the heated coolant; both channels are mechanically interconnected and are used as a stiffening element of the cabinet frame, and each of them contains at least one fitting with a flexible hose at its end corresponding to the respective fitting located where the electronic components to be cooled down reside; the inlet and outlet openings are implemented as a fitting for the inflow/return of the coolant.

A disadvantage of this cabinet lies in its complex design due to the presence of a large number of parts including the ducts for circulating the coolant.

A prior design of an electronic components cabinet is known (DE2231469 A1); it contains a corrugated heat exchanger that is united with an inner (hot) wall to form a duct for circulating the air heated by the electronic hardware and transferring the heat to its inner surface; this surface is united with the outer (cooled down) wall to form a duct for ventilating its outer surface with atmospheric air.

A disadvantage of this cabinet lies in the low cooling efficiency due to the use of a corrugated heat exchanger.

A prior design of an electronic components cabinet is known (SU1132377A1) that contains the external and internal casing, a compartment for radio-electronic equipment formed by the internal casing, and a heat exchanger.

The drawbacks of this cabinet are as follows: complex design and large dimensions. It also has low cooling efficiency due to the influence of external factors; specifically, being significantly affected by the ambient air temperature because atmospheric air is constantly being sucked into the system.

A prior design of an electronic components cabinet is known (RU2318299C2) (serving as a prototype) with a hermetically sealed internal space where electronic hardware units are located one above the other; the cabinet also includes a closed-loop cooling air circuit for transferring the heat from the hardware units and an air-water heat exchanger for cooling down the heated exhaust air from the cooling air circuit, which is located in the lower part of the cabinet and is connected to the supply duct and exhaust duct; the first section of the exhaust duct is for the upward flow of the exhaust air; the second section of the exhaust duct is for the downward flow of the exhaust air; there is also an air duct with airways of identical length to achieve equal flow resistance for individual electronic hardware units and to achieve separation between the cold supply air and the heated exhaust air by design; dual air ducts would also ensure the inflow of cold air with the same temperature to individual electronic hardware units.

US 2014/124168 A1 (DEAN STEVEN J [US] ET AL) describes A cooling system for a high performance computing system includes a closed-loop cooling cell having two compute racks and a cooling tower between the compute racks. Each compute rack includes at least one blade enclosure, and the cooling tower includes at least one water-cooled heat exchanger and one or more blowers configured to draw warm air from a side of the compute racks towards a back, across the water-cooled heat exchanger, and to circulate cooled air to a side of the compute racks towards a front. The cooling cell further includes a housing enclosing the compute racks and the cooling tower to provide a closed-loop air flow within the cooling cell. The cooling system further includes cooling plate(s) configured to be disposed between two computing boards within the computing blade, and a fluid connection coupled to the cooling plate and in fluid communication with the blade enclosure.

US 2015/003009 A1 (MOORE DAVID A [US] ET AL) describes methods and systems for cooling electronic components housed in a rack. An example system for cooling a rack may include a frame including a number of dividers internal to the rack that define a plurality of sections within the rack. Moreover, an example system for cooling electronic components housed in a rack may further include a number of electronics sections including at least a first number of electronic component, and a number of cooling sections including at least a first cooling that cools at least the first number of electronic components via heat transfer through the number of dividers.

Disadvantages of this system lie in the complexity of its operating principles, as well as bulky system dimensions and complex design resulting from the presence of a large number of parts including separate air supply and exhaust ducts.

### Brief description of the invention

The engineering objective of the submitted invention is to create a simple design of a cabinet for electronic equipment; the design would include a minimum number of parts and would make it possible to cool the electronic equipment without additional fans.

The engineering objective of the invention "*cabinet for electronic equipment"* is to simplify the design of the cabinet for electronic equipment while maintaining the ability to cool the electronic equipment inside it. Here, cooling is made possible by the work of the built-in fans of the electronic equipment. The simplification of the cabinet design is due to a minimum number of cabinet parts and a highly efficient (ergonomic) cabinet layout; meanwhile, the capability for adequate cooling of the electronic equipment in the cabinet is maintained.

The invention is defined by the features of independent claims 1 and 9. Further embodiments are defined in the dependent claims.

It is possible to implement a cabinet for electronic equipment where at least one central wall executed in the form of a screen will act as the internal wall of the air duct.

It is possible to implement a cabinet for electronic equipment where blanking plates are an auxiliary means used to complete the internal wall of the air duct.

It is possible to implement a cabinet for electronic equipment where the length of the air duct section with hot air up to the heat exchanger is greater than the length of the section of the air duct with cool air beyond the heat exchanger.

It is possible to implement a cabinet for electronic equipment where the heat exchanger is in the centre of the middle section of the U-shaped air duct.

It is possible to implement a cabinet for electronic equipment where the external walls are sealed.

It is possible to implement a cabinet for electronic equipment where an air-water heat exchanger is used for heat exchange.

It is possible to implement a cabinet for electronic equipment where a fluid heat exchanger is used for heat exchange.

It is possible to implement a cabinet for electronic equipment where the heat exchanger is located in the air duct and it divides the duct into two sections with different temperatures so that the heat exchanger connects to the external and internal walls of the cabinet.

The engineering objective of the invention "*a method of cooling electronic equipment in an electronic equipment cabinet"* is to provide for the cooling of electronic equipment in a simplified design cabinet (the above described concept) by utilizing the built-in fans of the electronic equipment.

The engineering objective is achieved by cooling the electronic equipment in a cabinet using an air duct formed directly by the external walls of the cabinet and at least four vertical guides as well as the surfaces of the electronic equipment, including the following process flow: the air heated by the electronic equipment is fed into the hot air duct section from the electronic equipment location by the built-in fans of the electronic equipment; the heated air is then cooled down as it passes from the hot section to the cool section by a heat exchanger that connects to the external and internal walls of the cabinet; then the cooled air is sucked in by the fans of the electronic equipment from the cool section of the air duct to the electronic equipment location, and the electronic equipment is cooled by flow of this air.

It is possible to achieve the specified objective by cooling the electronic equipment in a cabinet in which the hot air is cooled by 10-20 degrees in the heat exchanger as it passes from the hot section to the cool section.

The specified objective can be achieved by cooling electronic equipment in a cabinet in which the cooled air is sucked in by the fans of the electronic equipment from the cool section of the air duct to the location of the electronic equipment through the working holes in the electronic equipment surfaces that together with the blanking plates form the internal side and end walls.

Also, from the above description it is clear that the invention is limited by the appended claims.

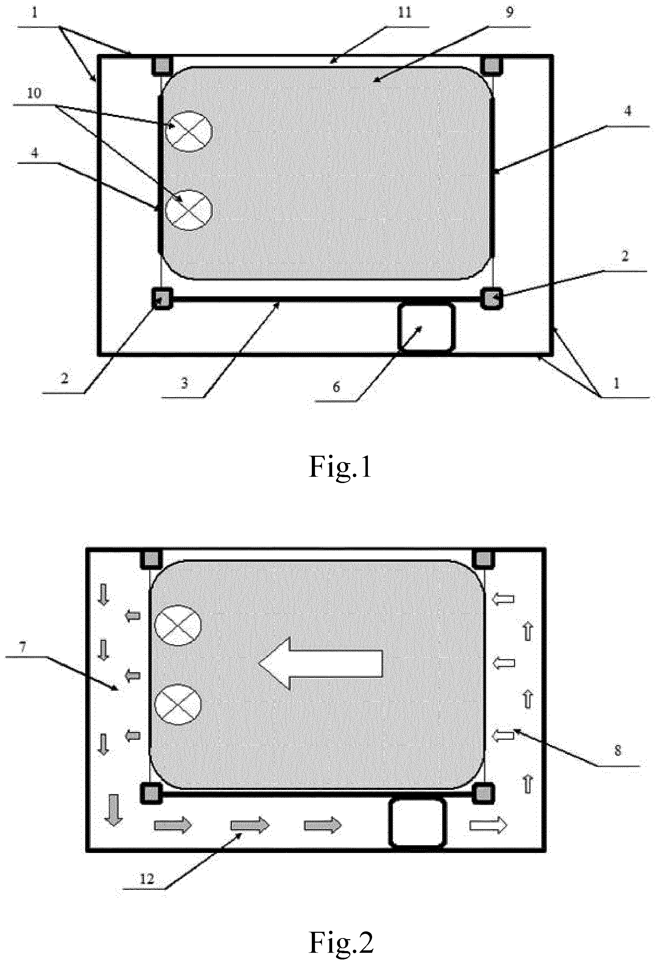

Figure 1 shows a sketch of a cabinet for electronic equipment.
Figure 2 shows a diagram of the movement of the air within the cabinet for electronic equipment.

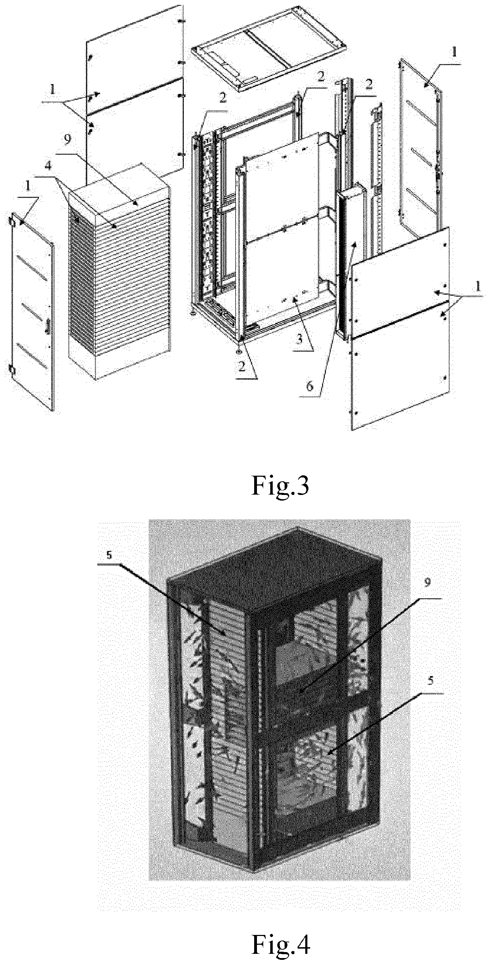

Figure 3 shows the structural elements of the cabinet for electronic equipment.
Figure 4 shows the structural elements of the cabinet for electronic equipment (the version with blanking plates).

Item 1 - external walls;
Item 2 - vertical guides;
Item 3 - screen;
Item 4 - electronic equipment surfaces;
Item 5 - blanking plates;
Item 6 - heat exchanger;
Item 7 - hot section of the air duct;
Item 8 - cool section of the air duct;
Item 9 - electronic equipment;
Item 10 - built-in fans of the electronic equipment;
Item 11 - electronic equipment area;
Item 12 - air duct;

The cabinet for electronic equipment comprises external walls (1) made of a metal or a polymer or a composite material that directly function as the external walls (1) of the air duct (12). The electronic equipment cabinet also comprises internal walls in one of the versions- made of at least four vertical guides (2) and surfaces (4) of the electronic equipment. In another version, the internal walls are made of six vertical guides (2) and the surfaces (4) of the electronic equipment. The number of vertical guides (2) depends on the electronic equipment (9) to be fastened to them (2) and a requirement for the vertical guides (2) and the surfaces (4) of the electronic equipment to form the internal surfaces of the air duct (i.e. the requirements put forward for the configuration of the internal wall of the air duct (12)). The electronic equipment cabinet also contains a heat exchanger (6) that can be designed for water, glycol or freon and that is located in the air duct (12); the air duct (12) consisting of two sections having different temperatures: the hot section (7) and the cool section (8). The temperature difference in the duct (12) is caused by two factors: the air in one part of the duct (7) is heated by the electronic equipment (9), and in the other part of the duct (8) the air is cooled by the heat exchanger (6). In the third version, the internal walls are formed by four vertical guides (2) made of a metal or a polymer or a composite material, the screen (3) which is a plastic or carbon or metal panel, and the surfaces of the electronic equipment (4); here, the electronic equipment (9) is mounted on the vertical guides (2) with the capability of providing air flow via the sections of the air duct (12) through the heat exchanger (6) by the built-in fans (10) of the electronic equipment (9).

Electronic equipment with built-in fans is mainly represented by uninterruptible power supply (UPS) units, switches and disk arrays.

The implementation of the external walls (1) in the cabinet for electronic equipment that are also the external walls of the air duct (12), and the implementation of the internal walls formed by at least four vertical guides (2) and surfaces (4) of the electronic equipment in such a way that the air duct (12) is formed between the internal and external (1) walls allows for reducing the number of parts while increasing the reliability of the cabinet design as there are no additional walls (casings, air bypass and air guide ducts) that serve to form the air duct (12). Here, the implementation of external (1) and internal walls in the electronic equipment cabinet whereby an air duct (12) between them is formed allows for the reduction of the cabinet weight. Thus, the engineering objective is achieved and cabinet design is simplified. It should also be noted that the air duct (12) formed between the internal and external (1) walls extends to the entire height of the cabinet, and this allows the air flowing from the electronic equipment (9) to move through the air duct (12) without significant resistance and cool down the electronic equipment located in the cabinet. This design feature is necessary for air circulation in the cabinet for electronic equipment by the equipment's built-in fans (10).

The location of the heat exchanger (6) inside the air duct (12) and, specifically, its vertical fastening to the screen (3) and to the inner side of one of the external walls (1) and hence its tight fitting to the external (1) and internal walls, can all significantly simplify the design of the electronic equipment cabinet as there are no dedicated zones, platforms and structural elements required for fastening the heat exchanger (6) in the cabinet. In our case, the heat exchanger (6) is naturally positioned in the air duct and fastened with simple (standard) fastenings to the existing screen (3) and to one of the external walls. In addition, this arrangement of the heat exchanger (6) is ergonomic, i.e. the optimal approach for utilizing the internal space of the electronic equipment cabinet, which also confirms that the engineering objective of design simplification has been achieved. Besides, this arrangement of the heat exchanger (6) allows for removal of the restrictions on the dimensions of the heat exchanger (6), since the heat exchanger (6) can be made to the entire height of the cabinet and the width of the screen (3), which allows the use of the built-in fans (10) of the electronic equipment for air circulation.

The implementation of the air duct (12) comprising two sections: the cool section (7) and the hot section (8) which allows for selecting the optimal duct width in the hot (7) and cool (8) sections. In this case, the division of the air duct (12) into two sections defines the geometry of the arrangement of the electronic equipment (9) in the cabinet, so it becomes clear which direction the electronic equipment (9) is facing, namely the direction where the built-in fans (10) are to supply the air. All this affects the engineering objective of design simplification as it directly impacts the ergonomics of the arrangement of the structural elements of the cabinet and the electronic equipment (9) in it. The possibility of air circulation in the electronic equipment cabinet is ensured by the built-in fans (10) of the electronic equipment as well as by the presence of hot (7) and cool sections (8) in the air duct (12).

The use of the vertical guides (2), the screen (3) and the surfaces (4) of the electronic equipment as the internal walls allows the already existing units (items 2, 3, 4 listed above) to function as the internal wall of the air duct (12), which eliminates the need for an additional structural element (casing, air duct wall), and this directly affects the solution of the engineering objective, i.e. design simplification, as the previously existing parts (items 2, 3, 4) (in the prototype) additionally perform another function - they replace other parts that used to perform this function. Unlike the prototype, there are no side walls, only the screen (3) remains, and in some cases, when the electronic equipment (9) has its own casing, the screen (3) is not needed, as the casing of the electronic equipment (9) acts as a screen (3).

In this case the important element is the geometry of the fastening of the electronic equipment (9) on the vertical guides (2) in the cabinet while ensuring the air flow through the sections of the air duct (12) through the heat exchanger (6) by means of the built-in fans (10) of the electronic equipment. In order to ensure such an air flow, it is necessary to take into account from the outset the gaps between the electronic equipment (9), the location of the electronic equipment (9) relative to the air discharge by the built-in fans (10) and the geometry (the vertical horizontal orientation of the electronic equipment relative to the vertical guides) of the electronic equipment fastening (9). This is important since the conditions for air circulation are created by the built-in fans (10) and the number of parts of the electronic equipment cabinet is reduced, which confirms the successful achievement of the engineering objective, i.e. cabinet design simplification.

The implementation of the electronic equipment cabinet where the length of the hot section (7) of the air duct is greater than that of the cool section (8) of the air duct allows for the ergonomic use of the cabinet's space while the air in the heat exchanger (6) and on the external (1) and internal walls is efficiently cooled, which affects the number of parts of the electronic equipment cabinet.

The implementation of the air duct (12) is U-shaped because of the simplicity of the assembly of external (1) and internal walls since the wall profiles are mostly flat and, therefore, in some cases a minimum number of fasteners will be used, which contributes to the engineering objective, i.e. design simplification.

Here, it must be noted that the profile of the air duct (12) depends on the internal and external walls (1), hence in the cases where the walls will have a non-flat shape (for example: the vertical guides and the external walls are rounded, the screen has the shape of an arc, etc.) the air duct (12) profile will change as well.

One of the ergonomic options for the deployment of the heat exchanger (6) is the implementation of the electronic equipment cabinet whereby the heat exchanger (6) is located in the centre of the middle part of the U-shaped air duct (12).

The pressure-tight implementation of the external walls (1) allows for the arrangement of an irrotational air flow inside the air duct (12). This, in turn, affects the possibility of cooling by the built-in fans (10) of the electronic equipment.

Depending on the configuration of the electronic equipment cabinet, an air-water heat exchanger (6) or a fluid heat exchanger (6) can be used. The choice of the heat exchanger (6) type depends on the type of the electronic equipment (9) to be installed.

The use of blanking plates (5) as the internal walls is necessary if an incomplete set of electronic equipment (9) is installed; this will ensure the smooth irrotational flow of air from the air duct (12) to the electronic equipment area (11) and from the electronic equipment area (11) to the air duct (12).

The electronic equipment in the cabinet is cooled down via the following workflow: when the electronic equipment is turned on (9), the built-in fans (10) are started and an air stream is created; the air flows from the hot section (heated air) (8) of the air duct (12) to the cool section (7) of the air duct (12) in the electronic equipment location (11). Then the air heated by the electronic equipment (9) is supplied to the hot section of the air duct (7) using the built-in fans (10) of the electronic equipment; the air flows from the area where the electronic equipment is located (11). After that, the heated air passes through the heat exchanger (6) adjacent to the external and internal walls of the cabinet and this is where the air is cooled; then it enters the cool section (8) of the air duct. Then, the cooled air is supplied from the cool section (8) of the air duct to the electronic equipment location (11). Finally, the electronic equipment (9) is cooled by the stream of air in the electronic equipment location (11).

In order to cool down the electronic equipment (9) in the simplified design cabinet by the built-in fans (10) of the electronic equipment, four successive operations have to be performed, and each of those affects the achievement of the set engineering objective.

The supply of heated air to the hot air duct section (7) by the built-in fans (10) of the electronic equipment from the electronic equipment location (11) makes it possible for the air to flow through the air duct (12), and it also creates a high-pressure area in the hot section (7) of the air duct and a low-pressure region in the electronic equipment location (11). At the same time, this ensures air flow through the heat exchanger from the hot section (7) to the cool section (8) of the air duct without forced propulsion.

Cooling hot air inside the heat exchanger (6) allows for the supply of cooled air to the electronic equipment (9) for the subsequent cooling of the electronic equipment (9). And its tight fit (6) to the external (1) and internal walls ensures that all heated air passes through the heat exchanger and is thus cooled.

The suction of the cooled air from the cool section (8) of the air duct to the electronic equipment location (11) takes place because a region of rarefied (low-pressure) air is created in front of the fans (10) and this ensures the creation of a stream of cooled air that is then used for cooling the electronic equipment (9).

The electronic equipment (9) is cooled by the stream of air in the electronic equipment location (11) and this, combined with all the above operations, ensures the achievement of the engineering objective.

Cooling the hot air by 10-20 degrees in the heat exchanger (6) as it passes from the hot section (7) to the cool section (8) allows for the supply of sufficiently cooled air to the electronic equipment (9) for its subsequent cooling (9). Also, a certain cooling of the air (by 10-20 degrees Celsius) in the heat exchanger (6) affects the dimensions of the heat exchanger (6) and the cooling efficiency of electronic equipment (9) in the cabinet. If we know the dimensions of the heat exchanger (6) we can choose the required fastening for it, and the fastener will consist of a minimum number of parts.

The suction of the cooled air by the built-in fans (10) of the electronic equipment from the cool section (8) of the air duct to the electronic equipment location (11) through the working holes in the surfaces (4) of the electronic equipment that form internal side and end walls together with blanking plates (5) allows for providing cooling of the electronic equipment (9), in cases where the cabinet is not fully equipped with electronic equipment (9), and the gaps in the internal walls are closed with blanking plates (5).

Thus, the submitted invention *"cabinet for electronic equipment"* significantly simplifies the design of the electronic equipment cabinet while maintaining the capability to cool electronic equipment. Meanwhile, the simplification of the cabinet design is achieved through the reduction in the number of required cabinet components and the optimized layout of the structural components and the electronic equipment contained inside, while the ability to adequately cool of the electronic equipment is maintained.

Here, the submitted invention "*a method of cooling electronic equipment in a cabinet for electronic equipment"* provides for cooling the electronic equipment in a cabinet of simplified design by using the built-in fans of the electronic equipment.

## Claims

1. A cabinet for electronic equipment (9) comprising external (1) and internal walls, an air duct (12), and a heat exchanger (6), wherein
an external wall (1) of the air duct (12) is directly formed by the external walls (12) of the cabinet,
an internal wall of the air duct (12) is formed by at least four vertical guides (2) and by surfaces (4) of the electronic equipment (9),
the heat exchanger (6) is located in the air duct (12), dividing it into two sections (7, 8) with different temperatures,
while the electronic equipment (9) is mounted on the vertical guides (2) that ensure air flow through the air duct (12) sections (7, 8) via the heat exchanger (6) by utilizing built-in fans (10) of the electronic equipment (9), **characterized in that**
the heat exchanger (6) connects the external (1) and internal walls of the cabinet, and
the heat exchanger (6) is located in a middle part of a U-shaped air duct (12).

2. The cabinet for electronic equipment (9) according to claim 1, **characterised in that** at least one central wall is additionally used to complete the internal wall of the air duct (12).

3. The cabinet for electronic equipment (9) according to claim 1, **characterised in that** blanking plates (5) are additionally used to complete the internal wall of the air duct (12).

4. The cabinet for electronic equipment (9) according to claim 1, **characterised in that** a length of a hot section (7) in the air duct_(12) up to the heat exchanger (6) is greater than a length of a cool section (8) in the air duct (16) beyond the heat exchanger (6).

5. The cabinet for electronic equipment (9) according to claim 3, **characterised in that** the heat exchanger (6) is located at the centre of the middle part of the U-shaped air duct (12).

6. The cabinet for electronic equipment (9) according to claim 1, **characterized in that** the external walls (1) are hermetically sealed.

7. The cabinet for electronic equipment (9) according to claim 1, **characterised in that** an air-water heat exchanger (6) is used.

8. The cabinet for electronic equipment (9) according to claim 1, **characterised in that** a fluid heat exchanger (6) is used.

9. A method of cooling electronic equipment (9) using an U-shaped air duct (12) directly formed by external walls (1) of a cabinet for the electronic equipment (9) and at least four vertical guides (2) and the electronic equipment surfaces (4); including the following sequence of operations:
an air heated by the electronic equipment (9) is fed into a hot section (7) of the air duct (12) from the electronic equipment location by built-in fans (10) of the electronic equipment (9),
the heated air is then cooled down as it passes from the hot section (7) to a cool section (8) of the air duct (12) via a heat exchanger (6) that connects the external (1) and internal walls of the cabinet and is located in a middle part of the U-shaped air duct,
the cooled down air is sucked in by the fans (10) of the electronic equipment (9) from the cool section (8) of the air duct (12) to the electronic equipment location,
the electronic equipment is cooled by the flow of this cooled air.

10. The method of cooling electronic equipment (9) according to claim 9, **characterised in that** the heated air is cooled by at least 10 degrees in the heat exchanger (6) as it passes from the hot section (7) to the cool section (8).

11. The method of cooling electronic equipment (9) according to claim 9, **characterised in that** the heated air is cooled by no more than 20 degrees in the heat exchanger (6) as it passes from the hot section (7) to the cool section (8).

12. The method of cooling electronic equipment (9) according to claim 9, **characterised in that** the cooled air is sucked in by the fans (10) of the electronic equipment (9) from the cool section (8) of the air duct (12) to the electronic equipment location through the working holes in the surfaces (4) of the electronic equipment (9) that together with blanking plates (5) form the internal walls of the air duct (12).

## Patentansprüche

1. Schrank der elektronischen Ausrüstung (9) besteht aus äußerem (l) und innerem Wänden, einem Luftkanals (12) und einem Wärmeaustauschapparat (6), dabei
ist die Außenwand (l) des Luftkanals (12) direkt durch die Außenwände (12) des Schranks gebildet,
die Innenwand des Luftkanals (12) ist mindestens durch vier vertikale Führungsschiene (2) und obere Teile (4) der elektronischen Ausrüstung (9) gebildet,
Wärmeaustauschapparat (6) im Luftkanal (12) unterteilt es in zwei Abschnitte (7, 8) mit unterschiedlichen Temperaturen,
und die elektronischen Ausrüstung (9), installierte auf vertikale Führungsschienen (2), die den Luftstrom in den Abschnitten (7, 8) des Luftrohrs (12) über den Wärmeaustauschapparat (6) durch der Verwendung der eingebauten Lüfter (10) der elektronischen Ausrüstung (9) liefern, ist damit gekennzeichnet, dass
sie auf solche Weise mithilfe von Wärmeaustauschapparat (6) die externen (l) und inneren Wände des Schranks verbindet,
während sich das Wärmeaustauschapparat selbst (6) im mittleren Teil des U-förmigen Luftkanals (12) befindet.

2. Schrank der elektronischen Ausrüstung (9) ist gemäß Abs.1 durch die Tatsache gekennzeichnet, dass mindestens eine zentrale Wand zusätzlich als Fortsetzung der Innenwand des Lüftungskanals verwendet wird (12).

3. Schrank der elektronischen Ausrüstung (9) ist gemäß Absatz 1 durch die Tatsache gekennzeichnet, dass, um die innere Wand des Lüftungskanals (12) zu vervollständigen, die Stöpsels (5) zusätzlich verwendet werden.

4. Schrank der elektronischen Ausrüstung (9) ist gemäß Abs. 1 durch die Tatsache gekennzeichnet, dass die Länge des Heizabschnitts (7) im Lüftungskanal (12), der zum Wärmeaustauschapparat (6) übergeht, viel länger als die Länge des Kühlabschnitts (8) im Lüftungskanal (16) hinter dem Wärmeaustauschapparat (6).

5. Schrank der elektronischen Ausrüstung (9) ist gemäß Abs. 3 durch die Tatsache gekennzeichnet, dass sich das Wärmeaustauschapparat (6) in der Mitte des mittleren Teils des U-förmigen Lüftungskanals (12) befindet.

6. Schrank der elektronischen Ausrüstung (9) gemäß Abs. 1 ist durch die Tatsache gekennzeichnet, dass die Außenwände (1) versiegelt sind.

7. Schrank der elektronischen Ausrüstung (9) ist gemäß Abs. 1 durch die Tatsache gekennzeichnet, dass ein Luft-Wasser-Wärmeaustauschapparat (6) in dem verwendet wird.

8. Schrank der elektronischen Ausrüstung (9) ist gemäß Abs.1 durch die Tatsache gekennzeichnet, dass ein Flüssigkeits-Wärmeaustauschapparat (6) in dem verwendet wird.

9. Die Methode zum Abkühlen der elektronischen Ausrüstung (9) mit dem U-förmigen Lüftungskanal (12), das direkt durch die Außenwände (l) des Schranks der elektronischen Ausrüstung (9) und mindestens vier vertikale Führungsschiene (2) gebildet wird, sowie durch Oberflächen der elektronischen Ausrüstung (4); enthält die folgende Operationsfolge:
die durch der elektronischen Ausrüstung erhitzte Luft (9) wird vom Standort der elektronischen Ausrüstung mithilfe von eingebauten Lüfter (10) der Elektronikausrüstung (9) in den Heizabschnitt (7) des Lüftungskanals (12) geliefert,
dann wird die erhitzte Luft abgekühlt, und von den Heizabschnitt (7) in den Kühlabschnitt (8) des Lüftungskanals (12) über das Wärmeaustauschapparat (6) übertragen, das die Außen- (I) und die Innenwände des Schranks und die Anschlüsse des Schranks verbindet und sich im mittleren Teil des U-förmigen Luftungskanals befindet,
gekühlte Luft wird von den Lüfter (10) der elektronischen Ausrüstung (9) vom Kühlabschnitt (8) des Luftungskanals (12) bis zur Position der elektronischen Ausrüstung absorbiert,
elektronischen Ausrüstung wird durch diesen Strom gekühlter Luft abgekühlt.

10. Die Methode zur Kühlung der elektronischen Ausrüstung (9) gemäß Abs. 9 ist durch die Tatsache gekennzeichnet, dass erhitzte Luft im Wärmeaustauschapparat (6) beim Übergang von Heizabschnitt (7) in den Kühlabschnitt (8) um mindestens 10 Grad abgekühlt wird.

11. Die Methode zur Kühlung der Elektronikausrüstung (9) gemäß Abs. 9 ist durch die Tatsache gekennzeichnet, dass im Wärmeaustauschapparat (6) beim Übergang von Heizabschnitt (7) in den Kühlabschnitt (8) nicht mehr als 20 Grad gekühlt wird.

12. Die Methode der Kühlung der elektronischen Ausrüstung (9) gemäß Abs. 9 ist durch die Tatsache gekennzeichnet, dass gekühlte Luft von Lüfter (10) der elektronischen Ausrüstung (9) aus dem Abschnitt (8) des Lüftungskanals (12) an die Position der elektronischen Ausrüstung über die Arbeitslöcher in den Oberflächen (4) der elektronischen Ausrüstung (9), die zusammen mit Stöpsels (5) die inneren Wände des Luftkanals bilden (12), absorbiert wird.

## Revendications

1. L'armoire de l'équipement électronique (9) est constituée d'une paroi externe (I) et d'une paroi interne, d'un conduit d'air (12) et d'un échangeur de chaleur (6), de plus
la paroi externe (I) du conduit d'air (12) est directement formée par les parois externes (12) de l'armoire,
la paroi interne du conduit d'air (12) est formée au minimum par quatre parties supérieures (4) et orientées verticalement (2) équipement électronique (9),
échangeur de chaleur (6) situé dans le conduit d'air (12), il le partage en deux sections (7, 8) avec des températures différentes,
tandis que l'équipement électronique (9) est installé sur les parties orientées verticalement (2) assurant l'arrivée de l'air dans les sections (7, 8) du conduit d'air (12) via l'échangeur de chaleur (6) grâce à l'utilisation de ventilateurs intégrés (10) de l'équipement électronique (9), sa spécificité réside dans le fait qu'
il relit ainsi les parois externe (I) et interne de l'armoire à l'aide de l'échangeur de chaleur (6),
donc comme l'échangeur de chaleur (6), il est situé dans la partie médianne en forme de U du conduit d'air (12).

2. La particularité de l'armoire de l'équipement électronique (9), conformément au point 1, réside dans le fait qu'au minimum une paroi centrale est utilisée complémentairement en qualité de prolongation de la paroi interne du conduit d'aire (12).

3. La particularité de l'armoire de l'équipement électronique (9), conformément au point 1, réside dans le fait que pour la terminaison de la paroi interne de la conduite d'air (12), des obturateurs (5) sont utilisés en complément.

4. La particularité de l'armoire de l'équipement électronique (9), conformément au point 1, réside dans le fait que la longueur de la section du chauffage (7) dans le conduit d'air (12) amenant à l'échangeur de chaleur (6) est plus grande que la longueur de la section de refroidissent (8) dans le conduit d'air (16) après l'échangeur de chaleur (6).

5. La particularité de l'armoire de l'équipement électronique (9), conformément au point 3, réside dans le fait que l'échangeur de chaleur (6) est situé au centre de la partie médiane en forme de U du conduit d'air (12).

6. La particularité de l'armoire de l'équipement électronique (9), conformément au point 1, réside dans le fait que les parois externes (1) sont hermétiques.

7. La particularité de l'armoire de l'équipement électronique (9), conformément au point 1, réside dans le fait qu'un échangeur de chaleur air-eau (6) y est utilisé.

8. La particularité de l'armoire de l'équipement électronique (9), conformément au point 1, réside dans le fait qu'un échangeur de chaleur liquide (6) y est utilisé.

9. Le procédé de refroidissement de l'équipement électronique (9) à l'aide du conduit d'air en forme de U (12) formant les parois externes directes (I) de l'armoire de l'équipement électronique (9) et par au moins quatre orientations verticales (2), et également les surfaces de l'équipement électronique (4), inclut la séquence d'opérations suivantes :
l'air réchauffé par l'équipement électronique (9) est délivré dans la section du chauffage (7) du conduit d'air (12) du lieu de l'emplacement de l'équipement électronique à l'aide des ventilateurs intégrés (10) de l'équipement électronique (9),
ensuite l'air chaud est refroidi en passant de la section de chauffage (7) à la section de refroidissement (8) du conduit d'air (12) via l'échangeur de chaleur (6) reliant les parois externe (I) et interne de l'armoire et situé dans la partie médiane du conduit d'air en forme de U
l'air refroidi est aspiré par les ventilateurs (10) de l'équipement électronique (9) depuis la section de refroidissement (8) du conduit d'air (12) vers le lieu d'emplacement de l'équipement électronique,
l'équipement électronique est refroidi par ce flux d'air froid.

10. La particularité du procédé de refroidissement de l'équipement électronique (9), conformément au point 9, réside dans le fait que l'air chaud est refroidi d'au moins 10 degrés dans l'échangeur de chaleur (6) lors du passage de la section de chauffe (7) vers la section de refroidissement (8).

11. La particularité du procédé de refroidissement de l'équipement électronique (9), conformément au point 9, réside dans le fait que l'air chaud est refroidi d'au plus 20 degrés dans l'échangeur de chaleur (6) lors du passage de la section de chauffe (7) vers la section de refroidissement (8).

12. La particularité du procédé de refroidissement de l'équipement électronique (9), conformément au point 9, réside dans le fait que l'air refroidi est aspiré par les ventilateurs (10) de l'équipement électronique (9) depuis la section de refroidissement (8) de la conduite d'air (12) vers le lieu de l'emplacement de l'équipement électronique via des orifices de fonctionnement sur les surfaces (4) de l'équipement électronique (9), qui avec les obturateurs (5) forme les parois internes du conduit d'air (12).
